**Europäisches Patentamt**

**European Patent Office**

**Office européen des brevets**

(19)

(11) Numéro de publication: **0 040 580
B1**

## (12) FASCICULE DE BREVET EUROPEEN

(45) Date de publication du fascicule du brevet:
**22.08.84**

(21) Numéro de dépôt: **81810170.1**

(22) Date de dépôt: **05.05.81**

(51) Int. Cl.³: **H 05 K 13/00, H 01 L 21/68**

(54) **Dispositif pour l'alignement d'une pièce et d'un substrat.**

(30) Priorité: **19.05.80 CH 3877/80**

(43) Date de publication de la demande:
**25.11.81 Bulletin 81/47**

(45) Mention de la délivrance du brevet:
**22.08.84 Bulletin 84/34**

(84) Etats contractants désignés:
**BE CH DE FR GB LI LU NL SE**

(56) Documents cités:
**FR - A - 2 235 416
US - A - 3 645 622
US - A - 3 858 978
US - A - 3 909 933**

(73) Titulaire: **Les Fabriques d'Assortiments Réunies, 57, rue Girardet, CH-2400 Le Locle (CH)**

(72) Inventeur: **Lebet, Jean-Philippe, 22, rte de Coffrane, CH-2206 Les Geneveys sur Coffrane (CH)**
Inventeur: **Peterle, Leonardo, CH-2115 Buttes (CH)**
Inventeur: **Matthey-Doret, Fernand, Communal 16, CH-2400 Le Locle (CH)**

(74) Mandataire: **Schneider, Jürg et al, c/o ASUAG Faubourg du Lac 6, CH-2501 Bienne (CH)**

ACTORUM AG

## Description

La présente invention concerne un dispositif pour l'alignement d'une pièce et d'un substrat prévu pour la recevoir. Elle concerne plus particulièrement un tel dispositif adapté pour le montage de microplaquettes semiconductrices sur une base portant un motif de circuits électriques.

La réalisation d'une liaison électrique et mécanique entre une micro-plaquette et un substrat conduit le plus souvent à procéder, préalablement à l'établissement de la liaison, à l'alignement de la plaquette relativement au substrat, puis à un second alignement de l'ensemble plaquette-substrat relativement à un outil, par exemple de soudage. Il existe également des modes de réalisation dans lesquels la microplaquette est tout d'abord orientée relativement à l'outil, puis rendue solidaire de cet outil. Le substrat est alors aligné relativement à l'ensemble outil-microplaquette.

C'est pourquoi, les installations de montage de microplaquettes incorporent généralement un dispositif d'alignement comportant notamment une table à déplacement en XY permettant de déplacer la pièce ou le substrat selon deux directions horizontales orthogonales, et susceptible de tourner autour d'un axe vertical ainsi qu'un dispositif optique pour surveiller l'opération d'alignement. De façon schématique, chaque opération d'alignement, par exemple d'une pièce et d'un substrat porté par la table XY, consiste alors à déplacer la table XY selon deux directions orthogonales, de telle façon que les axes de la pièce et du substrat se superposent, puis à imprimer au substrat une rotation qui l'aligne aussi angulairement avec la pièce.

Dans la plupart des dispositifs d'alignement connus, on constate que lorsque l'axe du substrat n'est pas confondu avec l'axe de rotation de la table XY, toute rotation de celle-ci modifie la position de l'axe du substrat. Il faut donc, après la rotation, recourir à un nouveau réglage en XY pour obtenir un alignement parfait.

Dans d'autres dispositifs, du type de celui décrit dans le brevet USA 3 909 933, la table XY n'est plus constituée de façon à tourner autour d'un axe fixe relativement à la base de montage de l'installation mais elle porte un support pour le substrat qui, lui, est monté en rotation sur la table XY. Il suffit alors de placer le substrat sur le support de façon à ce que son axe corresponde exactement à l'axe de rotation du support pour que l'inconvénient précédemment cité disparaisse. Ceci implique toutefois une opération d'alignement supplémentaire qui dans le document susmentionné est réalisée au moyen d'une deuxième table XY et doit en outre être répétée dans le cas où un même substrat comporte plusieurs sites pour recevoir des pièces. Un autre désavantage de cette solution est que, l'axe de rotation n'étant plus fixe relativement à la base de montage de l'installation, il peut s'écarter de l'axe optique du dispositif d'observation, ce qui conduit à de nouvelles difficultés pour ensuite aligner l'ensemble pièce-substrat relativement à l'outil de soudage qui est souvent disposé également sur l'axe optique ou du moins sur un axe fixe parallèle. Un décalage entre l'axe optique et l'axe pièce-support peut en outre provoquer des distorsions de l'image.

Un autre inconvénient encore des dispositifs connus est que pour réaliser des translations importantes, par exemple pour passer d'un site d'implantation du substrat à un autre il faut utiliser les déplacements généralement lents de la table XY.

C'est pourquoi, un objet de la présente invention, telle qu'elle est définie dans la revendication principale, est de prévoir un dispositif d'alignement en supprimant les défauts des dispositifs de l'art antérieur.

L'invention sera mieux comprise à la lecture de la description suivante faite en référence aux dessins joints, parmi lesquels:

– la figure 1 est une vue en coupe partielle d'un mode de réalisation du dispositif de l'invention; et

– la figure 2 est une vue en plan de la buse d'aspiration du dispositif de préhension de la figure 1.

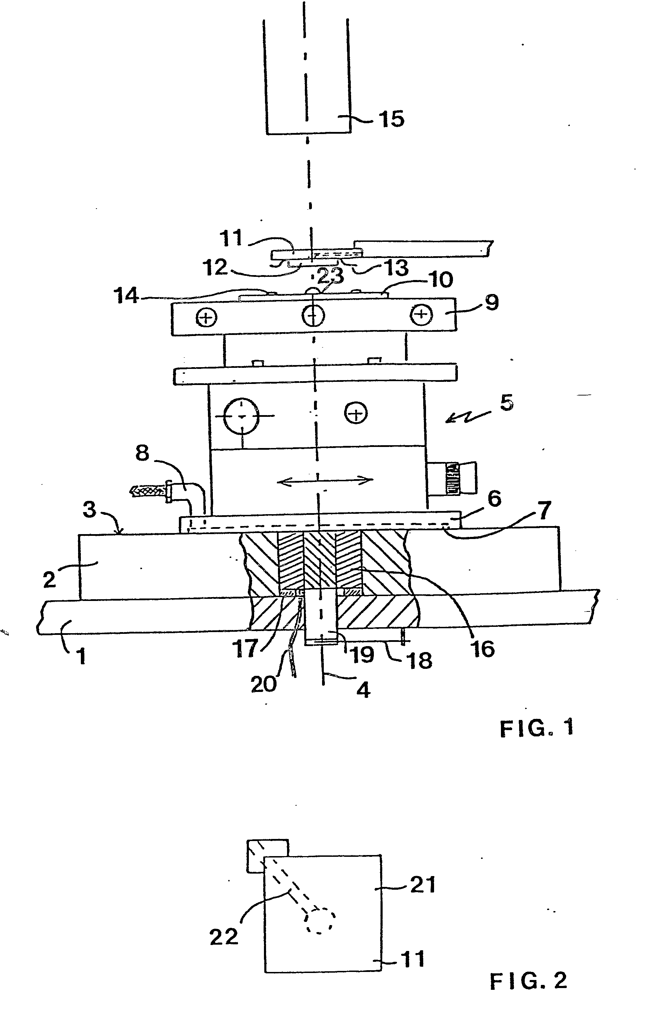

Dans la figure 1, on a représenté en 1 la base de montage du dispositif d'alignement, qui peut être également, par exemple celle d'une machine de soudage incorporant ce dispositif. Un plateau 2 présentant une surface supérieure 3 plane horizontale es solidaire de la base 1 et il comporte un alésage central d'axe vertical fixe 4. Une table XY généralement référencée 5 est montée sur un socle 6 susceptible de glisser sur la surface 3 du plateau 2. Un évidement 7 de la surface inférieure du socle 6, raccordé par une conduite 8 à une source de surpression, permet de faciliter ce déplacement. L'évidement 7 peut aussi être raccordé sélectivement à une source de dépression pour immobiliser la table 5 sur le plateau 2. Un support 9 solidaire de la table XY est prévu pour le substrat 10.

Un dispositif de préhension comportant par exemple une buse d'aspiration 11, est adapté pour amener sensiblement dans le prolongement de l'axe vertical 4 est par des moyens non représentés, la pièce 12 constituée ici par une microplaquette semi-conductrice munie de pattes de connexion 13 à raccorder aux plages conductrices 14 formées selon un motif correspondant sur le substrat 10, puis pour la déposer verticalement sur le substrat où elle peut être retenue par exemple par une goutte de matériau adhésif 23.

Un dispositif optique 15, disposé également dans le prolongement de l'axe 4 permet de surveiller les opérations d'alignement. Enfin, le dispositif de l'invention comporte un dispositif de blocage pour interdire momentanément tout mouvement de translation du socle 6 sur la surface 3 du plateau 2, mais le laissant libre en rotation autour de l'axe vertical 4. Ce dispositif de blocage est constitué par l'électro-aimant 16 monté librement dans l'alésage du plateau 2 de telle façon que lorsqu'il est mis momentanément sous tension, il développe une force d'attraction verticale suffisante pour retenir radialement le socle 6. Une rondelle élastique 17 permet de solliciter constamment l'électro-aimant 16 contre la surface inférieure du socle 6, tandis qu'un ressort de rappel 18 dont l'une des extrémités est fixée à la base de montage 1 et dont l'autre collabore avec un axe 19 prolongeant l'électro-aimant 16 du côté opposé au socle 6 le ramène en permanence vers une position angulaire moyenne pour éviter l'enroulement des fils d'alimentation électriques 20.

Dans la figure 2 on a représenté en plan un mode de réalisation préférentiel de la buse d'aspiration 11, qui est formée d'une plaque carrée transparente 21 réalisée par exemple en un matériau synthétique du type de celui connu sous la dénomination commerciale «Plexiglass». La plaque 21 comporte un canal d'alimentation radial 22 susceptible d'être raccordé à une source de dépression, et débouchant au centre de la face inférieure de la buse contre laquelle doit être retenue la microplaquette par aspiration. Le canal radial 22 s'étend de préférence selon une diagonale de la plaque carrée 21, de façon à ne point gêner la vision des pattes de connexion de la microplaquette qui présente également le plus souvent une configuration carrée, les pattes de connexion étant raccordées sur ses côtés uniquement.

La mise en œuvre du dispositif de l'invention est particulièrement simple. Le dispositif de préhension ayant amené une microplaquette 12 de telle façon que son axe se superpose sensiblement à l'axe 4 et l'électro-aimant 16 n'étant pas excité, l'opérateur déplace rapidement la table XY 5 sur le plateau 2 pour amener l'axe du substrat 10, ou du site de ce substrat qui soit recevoir la microplaquette 12 dans le prolongement de l'axe de cette dernière. Puis, après avoir mis l'électro-aimant 16 sous tension pour bloquer les mouvements de translation du socle 6, il déplace la table XY 5 en rotation autour de l'axe 4 pour aligner angulairement la plaquette et le substrat. Le cas échéant, il ne lui reste plus qu'à parfaire le positionnement du substrat en manœuvrant la table XY. L'ensemble des opérations est surveillé au moyen du dispositif optique 15 qui peut être constitué par un microscope ou une caméra de télévision. Lorsque le positionnement relatif du substrat et de la microplaquette est correct, le dispositif de préhension dépose verticalement la plaquette. Si nécessaire, l'ensemble substrat-plaquette peut alors être à nouveau aligné par rapport à la position de l'outil, visualisée par exemple au moyen d'un repère associé au dispositif optique.

Bien qu'elle ait été décrite en liaison avec un mode de réalisation particulier, la présente invention est suceptible de nombreuses variantes et modifications qui apparaîtront à l'homme de l'art.

Par exemple, le dispositif optique peut être associé à un ensemble de commande automatique des déplacements de la table 5 en translation et/ou en rotation.

Da la même façon, l'électro-aimant 16 pourrait aussi être remplacé par tout autre dispositif remplissant la même fonction, comme par exemple une buse d'aspiration cylindrique.

Selon une autre variante encore, le plateau 2 pourrait être monté en rotation libre sur la base de montage 1 et comporter des dispositifs de blocage quelconques pour interdire les translations du socle 6.

## Revendications

1. Dispositif pour l'alignement d'une pièce (12) et d'un substrat (10) prévu pour la recevoir, comprenant

- un plateau (2) présentant une surface supérieure plane horizontale (3), monté sur une base de montage fixe (1);
- une table à déplacement en XY (5) solidaire d'un socle (6) susceptible de glisser sur la surface supérieure (3) du plateau et prévue pour supporter le substrat;
- un dispositif de blocage (16) pour interdire momentanément tout mouvement de translation du socle sur la surface supérieure du plateau mais le laissant libre en rotation autour d'un axe vertical déterminé;
- un dispositif de préhension (11) pour amener la pièce au-dessus du substrat, sensiblement dans l'axe vertical déterminé et l'y déposer verticalement; et
- un dispositif optique (15) pour observer la pièce et le substrat selon une direction d'observation confondue avec l'axe vertical déterminé.

2. Dispositif selon la revendication 1, caractérisé en ce que le dispositif de blocage est un électro-aimant (16) monté librement en rotation autour de l'axe vertical déterminé dans un alésage (4) du plateau (2), ce dernier étant rigidement assujetti à la base (1) de montage fixe, ledit électro-aimant développant une force d'attraction suffisante pour retenir radialement le socle de la table à déplacement XY lorsqu'il est mis momentanément sous tension.

3. Dispositif selon la revendication 2, caractérisé en ce que l'électro-aimant (16) est sollicité contre la surface inférieure du socle sous l'action d'une rondelle élastique (17).

4. Dispositif selon la revendication 2 ou la revendication 3, caractérisé en ce que l'électro-aimant (16) est rappelé angulairement par un ressort (18) collaborant avec un axe prolongeant l'électro-aimant du côté opposé au socle (6).

5. Dispositif selon l'une quelconque des revendications précédentes, caractérisé en ce que le dispositif de préhension comporte une buse d'aspiration (11) transparente.

6. Dispositif selon la revendication 5, caractérisé en ce que la buse d'aspiration (11) présente la forme d'une plaque carrée (21) comportant un canal d'alimentation (22) radial débouchant au centre de l'une des faces.

7. Dispositif selon la revendication 6, caractérisé en ce que le canal d'alimentation (22) s'étend selon l'une des diagonales de la plaque carrée.

8. Dispositif selon l'une quelconque des revendications précédentes, caractérisé en ce que le socle (6) comporte sur sa surface inférieure au moins un évidement (7) susceptible d'être raccordé sélectivement à une source de surpression ou de dépression.

## Patentansprüche

1. Vorrichtung zum Ausfluchten eines Teils (12) und eines Substrats (10), vorgesehen zur Aufnahme des ersteren, umfassend
– ein Plateau (2), das eine obere ebene horizontale Oberfläche (3) aufweist und auf einer festen Montagebasis (1) montiert ist,
– einen in XY-Richtung versetzbaren Tisch (5), verbunden mit einem Sockel (6), gleitbeweglich auf der oberen Oberfläche (3) des Plateaus und vorgesehen zur Halterung des Substrats,
– eine Blockiereinrichtung (16) zum zeitweisen Unterbinden jeglicher Translationsbewegung des Sockels auf der oberen Oberfläche des Plateaus, jedoch unter Freigabe der Drehung des Sockels um eine bestimmte Vertikalachse,
– eine Greifereinrichtung (11) zum Bewegen des Teils oberhalb des Substrats im wesentlichen in der bestimmten Vertikalachse und zum vertikalen Absetzen desselben und
– eine optische Einrichtung (15) zum Beobachten des Teils und des Substrats in einer Beobachtungsrichtung, die mit der bestimmten Vertikalachse zusammenfällt.

2. Vorrichtung nach Anspruch 1, dadurch gekennzeichnet, dass die Blockiereinrichtung ein Elektromagnet (16) ist, der drehbeweglich um die bestimmte Vertikalachse in einer Ausnehmung (4) des Plateaus (2) angeordnet ist, welches letztere starr mit der festen Montagebasis (1) verbunden ist, wobei der Elektromagnet eine Haltekraft entwickelt, die hinreicht zum radialen Festlegen des Sockels in dem in XY-Richtung beweglichen Tisch, sobald er zeitweilig unter Spannung gesetzt wird.

3. Vorrichtung nach Anspruch 2, dadurch gekennzeichnet, dass der Elektromagnet (16) an der unteren Oberfläche des Sockels unter Wirkung eines elastischen Rings (17) in Anlage gehalten ist.

4. Vorrichtung nach Anspruch 2 oder 3, dadurch gekennzeichnet, dass der Elektromagnet (16) in Winkelrichtung von einer Feder (18) vorgespannt ist, die mit einer Achse in Wirkverbindung steht, welche den Elektromagnet auf der dem Sockel (6) abgewandten Seite verlängert.

5. Vorrichtung nach einem der vorangehenden Ansprüche, dadurch gekennzeichnet, dass die Greifervorrichtung eine durchsichtige Ansaugdüse (11) umfasst.

6. Vorrichtung nach Anspruch 5, dadurch gekennzeichnet, dass die Ansaugdüse (11) die Form einer quadratischen Platte (21) aufweist mit einem radialen Speisekanal (22), der im Zentrum einer ihrer Seiten mündet.

7. Vorrichtung nach Anspruch 6, dadurch gekennzeichnet, dass der Speisekanal (22) sich längs einer Diagonale der quadratischen Platte erstreckt.

8. Vorrichtung nach einem der vorangehenden Ansprüche, dadurch gekennzeichnet, dass der Sockel (6) auf seiner Unterseite mindestens eine Ausnehmung (7) aufweist, die selektiv an eine Überdruck- oder Unterdruckquelle anschliessbar ist.

## Claims

1. Apparatus for aligning a component (12) and a substrate (10) adapted to receive it, comprising:
– a platen (2) having a flat horizontal upper surface (3), mounted on a stationary mounting base (1);
– an XY-displacement table (5) rigid with a stand (6) slidably mounted on the upper surface (3) of the platen and adapted to support the substrate;
– blocking means (16) for momentarily preventing translatory movement of the stand on the upper surface of the platen while leaving it free to rotate about a set vertical axis;
– holding means (11) for moving the component above the substrate, in substantial alignment with said vertical axis, and for depositing the component vertically on the substrate; and
– optical means (15) for sighting the component and the substrate in a sighting direction coinciding with said set vertical axis.

2. Apparatus as in claim 1, characterized in that the blocking means are an electro-magnet (16) mounted for free rotation about said set vertical axis in a bore (4) formed in said platen (2), the latter being rigidly secured to the stationary mounting base (1), said electro-magnet generating a pull sufficient radially to hold the stand of the X-Y displacement table when it is momentarily energized.

3. Apparatus as in claim 2, characterized in that the electro-magnet (16) is urged against the lower surface of the stand under the action of an elastic washer (17).

4. Apparatus as in claim 2 or 3, characterized in that the electro-magnet (16) is returned angularly by a spring (18) cooperating with a shaft (19) extending the electro-magnet to the side thereof away from the stand (6).

5. Apparatus as in any preceding claim, characterized in that the holding means include a transparent suction nozzle (11).

6. Apparatus as in claim 5, characterized in that the suction nozzle (11) is formed by a square plate (21) having a radial supply duct (22) opening in the centre of one of its faces.

7. Apparatus as in claim 6, characterized in that the supply duct (22) extends along one of the diagonals of the square plate.

8. Apparatus as in any preceding claim, characterized in that the stand (6) is formed on its lower surface with a recess (7) selectively connectable to a source of positive or negative pressure.

0040580

FIG. 1

FIG. 2